# EUROPEAN PATENT APPLICATION

(11) **EP 1 883 124 A1**
(43) Date of publication of application: **30.01.2008**
(21) Application number: 06117971.9
(22) Date of filing: 27.07.2006
(51) Int. Cl.: H01L 51/54

(54) **Organic light emitting material formulation**

(71) Applicant: IEE INTERNATIONAL ELECTRONICS & ENGINEERING S.A., 6468 Echternach (LU)
(72) Inventor: Brunacci, Antonio, 2651, LUXEMBOURG (LU); Jouanique-Dubuis, Cécile, 57570, Evrange (FR)
(74) Representative: Ocvirk, Philippe

(57) **Abstract**

A formulation of light-emitting material particularly suitable for forming displays and lamps via printing techniques comprises organic light emitting material housed in protective porous matrix material; a binder; and a solvent. The matrix material is selected from microporous and mesoporous materials, such as zeolites, porous oxides, molecular sieves, silicoaluminophosphates and aluminosilicates.

## Description

### TECHNICAL FIELD

The present invention generally relates to organic light emitting materials and more precisely to a formulation of such material for the manufacture of devices such as lamps and displays.

### BACKGROUND ART

In the 1980's a new and promising lighting technology emerged: the organic light-emitting diodes (OLEDs) were aiming to break through the world of displays with flat emitting surface, high brightness and contrast for low power voltages. The light-emitting materials used first were small organic molecules processed by vacuum evaporation, a high cost technology. Ten years later, Cambridge Display Technology (United Kingdom) unveiled a polymer light-emitting device (PLED) based on conjugated polymers with similar light performance but with a much easier processability as it can be put in solution and then processed by economical solution processing techniques, such as spin coating, but more particularly inkjet printing or screen printing. Such solution processable polymer material allows mass production at low costs of simple or sophisticated displays, and can therefore compete with LCD-displays.

Despite this, OLEDs (and hence PLEDs) suffer from a high sensitivity to oxygen and moisture, and must therefore be protected from natural oxidation during the manufacturing phase and during their lifetime in a lamp or display. Consequently, class 1000 clean room and inert atmospheres are the usual mandatory production conditions. Typically, in the manufactured display or lamp, the active organic light emitting materials are mechanically sandwiched between sheets of glass, or a combination of glass sheet and metal, along with a dessicant to absorb moisture penetrating the adhesive seal at the edges. Such moisture protections are heavy and rigid while adding significant costs, thereby reducing the advantages of the OLED technology over the LCD technology.

In order to avoid rigid encapsulation of the organic light emitting material, US 2003/0032361 proposes a method of manufacturing an EL lamp from light emitting polymers, wherein particles of organic light emitting polymer are encapsulated with a conductive polymer or thin, isolative polymer to provide emitting polymer stability. Although such particles are interesting since they can be formulated into an ink system that can be printed to form a lamp or display, their preparation obviously increases complexity and costs.

Another way of improving the stability of organic light emitting material is disclosed in WO 2004/002890, which describes the encapsulation of conjugated polymers in a protective matrix consisting of zeolites or other inert, rigid materials having micro- or mesoporosity. Although the resulting material fulfills the stability requirement, it could not be processed for the making of a light emitting device in industrial production conditions, especially due to the particular nature of the protective matrix material.

### OBJECT OF THE INVENTION

The object of the present invention is to provide an improved formulation of organic light emitting material that is stable, easily processable and well adapted for production at industrial scale. This object is achieved by a formulation as claimed in claim 1.

### GENERAL DESCRIPTION OF THE INVENTION

According to the present invention, a formulation comprises organic light emitting material housed in protective porous matrix material mixed with a binder and a solvent. The present invention thus proposes a solution processable formulation of organic light emitting material that is chemically stable-due to the use of the porous matrix material-and is suitable for solution processing techniques at industrial scale, such as e.g. inkjet or screen printing. A particular merit of the invention is to have thought of combining the matrix housed emitting material with binder (for the cohesion and fastness of the deposit) and solvent (for processability) materials.

Stability and durability of the organic light emitting material is achieved by its incorporation into the interior of the protective porous matrix material (typically inert and rigid), which interior spaces define compartimentalised spaces wherein the organic light emitting material is housed. The matrix of the porous material protects the encapsulated host from attack by outside agents. At the same time, such incorporation inside the pores of the matrix allows the presence of other compounds. For example, the pores may additionally contain other hosts or ions which act by donating or accepting electrons (co-doping compounds) or by modifying any property of the light emitting material.

The protective matrix material is preferably selected from among microporous and mesoporous materials such as, e.g., zeolites, porous oxides, molecular sieves, silicoaluminophosphates and aluminosilicates. The terms mesoporous and microporous herein designate materials having pores with diameters in the range of 2 to 50 nm (sometimes 2-100 nm), respectively smaller than 2 nm (IUPAC pore classification). Particularly preferred matrix materials (according to IUPAC nomenclature) are: (1) mesoporous molecular sieves such as MCM-41, MCM-48, HSM, SBA-15 and any of their combinations, preferably with Al/Si ratio between 5 and infinite; and (2) zeolites frameworks such as MWW (also known as MCM-22), MFI (also known as ZSM-5), Faujasite (NaY, NaX, CsX, etc), Linde Type L (LTL) and the like. It remains to be noted that zeolites and aluminosilicates could contain in their structure elements other than Si and Al, such as Ge, Fe(III), Ti, V, Sn and combinations thereof, since the electronic structure of these elements can interact with the electronic structure of the zeolites framework.

It will be appreciated that the inclusion of organic light emitting material into such protective matrix materials avoids the need for hermetic sealing against moisture and other compounds, which greatly facilitates the handling of such emitting material, while decreasing manufacturing costs and production costs of devices using such materials and increasing service lifetime.

In addition to the improved stability of the inventive formulation, the latter further shows-as already mentioned-an improved processability adapted for industrial production, as well as an enhanced coherence of the deposit. As a matter of fact, the present inventors have observed that the simple deposition of stable zeolite encapsulated organic light emitting material, as e.g. described in WO 2004/002890, does not produce a viable layer, since the powders completely lack cohesion to withstand mechanical stresses. Therefore, a binder is used in the present formulation, which provides desirable fastness and cohesion properties.

A variety of solvents and binders can be used, a minimum requirement being their compatibility with the protective matrix material. The choice in solvent and binder (and their relative amounts) is preferably made to permit deposition of a layer of light emitting material having excellent thickness uniformity, which ensures uniform light emission. In this respect, it is preferable to use formulations which exhibit the desired properties with respect to surface tension, viscosity and concentrations. More specifically, the formulation should preferably satisfy the following requirements:
- appropriate viscosity to print a layer of the right thickness and uniformity;
- appropriate solvent to print in mass production;
- appropriate solvent and binder to ensure good particles dispersion;
- appropriate binder to ensure that particles are well embedded;
- appropriate binder to ensure the adhesion of the layer onto the substrate;
- appropriate particles size and shape to ensure a good dispersion;
- appropriate particles/binder ratio to guarantee maximal level of light emission.

Examples of solvents and binders that permit to achieve these preferred requirements are mentioned hereafter.

The main function of the solvent being to provide the required processability of the formulation, it may typically be removed from the formulation upon deposition of a layer of the formulation. This may be done by thermal drying, typically by subjecting the deposited layer to heat or infra-red treatment, or by any other appropriate means depending on the chemistry of the binder.

The solvent may in particular be selected from following list of compounds that have good compatibility with the protective matrix material and can be rapidly removed by drying (e.g. in an oven at temperatures between 100 and 200°C):
- esters, such as ethyl acetate, n-propyl acetate, isopropyl acetate, isobutyl acetate, n-butyl acetate and primary amyl acetate mixed isomers;
- glycol ethers such as ethylene glycol monomethyl ether, ethylene glycol monoethyl ether, diethylene glycol monomethyl ether, and the like;
- glycol ether esters such as ethylene glycol monomethyl ether acetate, ethylene glycol monoethyl ether acetate, propylene glycol monomethyl ether acetate and the like;
- refined dimethyl esters of adipic, glutaric and succinic acids known as di-basic esters, isobutyl isobutyrate and the like;
- other polar solvents such as water, diethyl sulfate, dimethyl sulphoxide, 2-ethylhexanol, 2-ethylhexoic acid, 2-methyl butanol, diisobutyl carbinol, isobutanol, isophorone, isopropanol, methyl isobutyl carbinol, n-butanol, n-pentanol, n-propanol, primary amyl alcohol mixed isomers.

The binder's function is mainly to ensure the cohesion/adherence of the deposited layer, but will also have an impact on the precessability of the formulation. Possible materials for the binder are polymeric resins with or without ionic conductivity, e.g. an acrylic resin or a polyethylene oxide or a polyethylene glycol.

The binder may be in particular selected from the group comprising: thermoplastic acrylic resins, such as Paraloid®; styrene acrylic copolymers, polyacrylates, polyacrylic acid / esters; cellulose esters and their derivatives and/or copolymers; polystyrene and its derivatives; polymethacrylates, including poly(methyl methacrylate), and their derivatives; methacrylic copolymers; poly(ethylene oxide); polyethylene glycol; colloidal silica, including Ludox®; poly(vinyl alcohol); poly(para-phenylene terephthalate); fluoropolymers, including poly(tetrafluoroethylene), poly(vinylidinefluoride) and their copolymers and/or derivatives.

As for the organic light emitting material, polyphenylenevinylene (PPV) and its derivatives are particularly preferred. Nevertheless, a variety of organic light emitting materials can be used, as long as they can be incorporated in the matrix material. For example, the encapsulation of PPV inside zeolites and porous aluminosilicates is described in WO 2004/002890, incorporated herein by reference.

More generally, the organic light emitting material may be of the type that emit light when stimulated electrically, such as: light emitting polymers, light emitting oligomers or so-called small molecules (the term small-molecules typically designating namely but not exclusively, as is known in the art, material susceptible of emitting light under electric stimulated and having a medium molecular mass). A preferred listing of such materials is given below:
Light emitting Polymers:
   • polypyridine and its derivatives and/or copolymers;
   • poly(p-phenylene vinylene) and its derivatives and/or copolymers, such as: poly[2-methoxy-5-(2'-ethylhexyloxy)-1,4-phenylenevinylene]; poly[(2-methoxy-5-(2-ethylhexyloxy)-1,4-phenylene-vinylene)-alt-co-(4,4'-biphenylene-vinylene)]; poly[2-(6-cyano-6-methylheptyloxy)-1,4-phenylene]; poly[2-methoxy-5-(2-ethylhexyloxy)-1,4-(1-cyanovinylenephenylene)]; poly[{9-ethyl-3,6-bis(2-cyanovinylene)carbazolylene)}-alt-co-{2-methoxy-5-(2-ethylhexyloxy)-1,4-phenylene}].
   • polyfluorenes and its derivatives and/or copolymers, in particular: poly(9,9-dihexylfluorene) and its derivatives and/or co-polymers, such as poly(9,9-dihexylfluorenyl-2,7-diyl); poly[(9,9-dihexylfluorenyl-2,7-divinylenefluorenylene)]; poly[(9,9-dihexyl-2,7-(2-cyanodivinylene)fluorenylene)]; poly[(9,9-dihexylfluorenyl-2,7-diyl)-co-(1,4-benzo-{2,1',3}-thiadiazole)]; poly[(9,9-dihexylfluorenyl-2,7-diyl)-alt-co-(9,10-anthracene)]; poly[(9,9-dihexylfluorenyl-2,7-diyl)-alt-co-(2-methoxy-5-{2-ethylhexyloxy}-1,4-phenylene)]; poly[(9,9-dihexylfluorenyl-2,7-diyl)-co-(9,ethyl-3,6-carbazole)]; poly[(9,9-dihexylfluorenyl-2,7-diyl)-alt-co-(9,ethyl-3,6-carbazole)]; poly[{9,9-dihexyl-2,7-bis(1-cyanovinylene)fluorenylene}-alt-co-{2,5-bis(N, N'-diphenylamino)-1,4-phenylene}]; poly[(9,9-dihexylfluorenyl-2,7-diyl)-alt-co-(9,9'-spirobifluorene-2,7-diyl]; poly[(9,9-dihexylfluorenyl-2,7-diyl)-co-(2,5-p-xylene)]; poly[(9,9-dihexylfluorenyl-2,7-diyl)-co-(6,6'{2,2'-bipyridine})]; poly[(9,9-dihexylfluorenyl-2,7-diyl)-co-(6,6'-{2,2': 6',2"-terpyridine})]; poly[(9,9-dihexylfluorenyl-2,7-diyl)-co-(N,N'bis{p-butylphenyl}-1,4-diamino phenylene)]; poly[9,9-di-(2-ethylhexyl)-fluorenyl-2,7-diyl]; poly[(9,9-di(2-ethylhexyl)-fluorenyl-2,7-diyl)-co-(N, N'-diphenyl)-N, N'-di-(p-butyl phenyl)-1,4-diaminobenzene]; as well as poly(9,9-dioctylfluorene) and its derivatives and/or co-polymers, such as poly(9,9-dioctylfluorenyl-2,7-diyl); poly[(9,9-dioctylfluorenyl-2,7-diyl)-alt-co-(N,N'-bis{4-butylphenyl}-benzidine-N,N'-{1,4-diphenylene})]; poly[(9,9-dioctyl-2,7-divinylenefluorenylene)-alt-co-(9,10-anthracene)]; poly[(9,9-dioctyl-2,7-divinylenefluorenylene)-alt-co-(4,4'-biphenylene)]; poly[{9,9-dioctyl-2,7-divinylene-fluorenylene}-alt-co-{2-methoxy-5-(2-ethyl-hexyloxy)-1,4-phenylene}]; poly[{9,9-dioctyl-2,7-bis(2-cyanovinylene-fluorenylene}-alt-co-{2-methoxy-5-(2-ethyl hexyloxy)-1,4-phenylene}]; poly[{9,9-dioctylfluorenyl-2,7-diyl}-co-{1,4-(2,5-dimethoxy)benzene}]; poly[(9,9-dioctylfluorenyl-2,7-diyl)-co-(1,4-ethylenylbenzene)]; poly[(9,9-dioctylfluorenyl-2,7-diyl)-co-(1,4-diphenylene-vinylene-2-methoxy-5-{2-ethylhexyloxy}-benzene)]; poly[(9,9-dioctylfluorenyl-2,7-diyl)-co-(1,4-vinylenephenylene)]; poly[(9,9-dioctylfluorenyl-2,7-diyl)-alt-co-(N,N'-diphenyl)-N,N'-di(p-butyloxy-phenyl) 1,4-diaminobenzene)]; poly[(9,9-dioctyllfluorenyl-2,7-diyl)-alt-co-(9,9-di-{5-pentanyl}-fluorenyl-2',7'-diyl)]; poly[(9,9-dioctylfluorenyl-2,7-diyl)-co-(N,N'-diphenyl)-N,N'-di(p-butyloxyphenyl)-1,4-diaminobenzene)].
   • poly(3-alkylthiophenes), where alkyl can be from 6 to 16 C atoms.
Light Emitting Oligomers, such as:
   • 4,4'-bis(9-ethyl-3-carbazovinylene)-1,1'-biphenyl;
   • 9,10-bis[(9-ethyl-3-carbazoyl)-vinylenyl)]-anthracene;
   • 4,4'-bis(diphenylvinylenyl)-biphenyl;
   • 1,4-bis(9-ethyl-3-carbazovinylene)-2-methoxy-5-(2-ethylhexyloxy)benzene.
Small molecules:
   • Electro-Fluorescent and Phosphorescent Materials, such as: tris(2-phenylpyridine) iridium (III); tris(8-hydroxyquinolato) aluminum; tetra(2-methyl-8-hydroxyquinolato) boron; tris[1-phenyl-3-methyl-4-(2,2-dimethylpropan-1-oyl)-pyrazolin-5-one] terbium.
   • Light Emitting small molecules such as: lithium tetra(2-methyl-8-hydroxyquinolinato) boron; lithium tetra(8-hydroxyquinolinato) boron; bis(8-hydroxyquinolinato) zinc; bis(2-methyl-8-hydroxyquinolinato) zinc; tris(benzoylacetone)-mono-(phenanthroline) europium (III); tris(dibenzoylmethane)-mono-(phenanthroline) europium (III); tris(dibenzoylmethane)-mono-(5-aminophenanthroline) europium (III); tris(dinapthoylmethane)-mono-(phenanthroline) europium (III); tris(dibenzoylmethane)-mono-(4,7-diphenylphenanthroline) europium (III); tris(dibenzoylmethane)-mono-(4,7-dimethylphenanthroline) europium (III); tris(diphenoylmethane)-mono-(phenanthroline) europium (III); tris(dibenzoylmethane)-mono-(4,7-dihydroxy-phenanthroline) europium (III); tris(dibenzoylmethane)-mono-(4,7-dihydroxyloxy-phenanthroline) europium (III); tris(8-hydroxyquinoline) aluminum.

It will be understood that the protective matrix, the organic light emitting material, the solvent and the binder may each constitute of one compound, or of a blend of compounds.

As it has been understood, the present formulation is particularly adapted for use with printing techniques, and can therefore also be referred to as printable paste.

The present invention also concerns a light emitting device incorporating a light emitting layer obtained from the formulation defined above.

The present invention further concerns a method of manufacturing a light emitting device, wherein a formulation as defined above is used for depositing a layer of light emitting material by solution processing.

The manufacturing of a light emitting device with the formulation may typically involve:
providing a glass or plastics substrate coated with an anode layer (e.g. in the form of indium tin oxide). The anode can be patterned in the form of elongate strips; optionally, the anode can be coated with a hole transport layer. Depositing a layer of the present formulation by a solution processing technique, followed by thermal drying to remove the solvent. The obtained light emitting polymer layer may then be covered by an electron transport layer. The device structure may be completed by the deposition of a cathode layer, e.g. the cathode can be calcium or aluminium. This is only an exemplary way of using the present formulation in the manufacture of light emitting devices, and it will appear to those skilled in the art that the present formulation can advantageously and easily be applied to a variety of structures, by solution processing techniques.

In order to illustrate the present invention, two exemplary formulations have been prepared and printed on a substrate.

### Example 1

In the first example, Faujasite NaY framework structure (IUPAC nomenclature: |Na|[Si-O-Al]-FAU) obtained from Zeolyst International was used as luminophore host structure (i.e. matrix). The solvent was prepared by mixing 67 g of water with 33 g of DGMEA. 5 g of zeolite particles was added to the solvent and kept in an ultrasound bath at 30°C for 48 h. After the dispersion step, 5 g of polyethylene oxide (PEO) was added to the zeolites dispersion and blended mechanically. The paste was screen printed on a polyethylene therephtalate (PET) flexible substrate from Dupont using 75 Shore A squeegee and 500 mesh stainless steel screen. The deposited layer was dried at 100°C for 10 minutes in static oven. The quality of the dry layer, analyzed by optical microscopy, was rated "very good".

### Example B

In this second example, aluminosilicates spheric nano-particles (500 nm diameter) obtained from NanoScape AG as luminophore were employed as host structure/matrix. 50 g of di-basic esters (DBE) were used to disperse 5 g of particles. The dispersion was kept 24 h in an ultrasound bath at 30°C. After the dispersion step, 35 g of A11-Paraloid™ from Rohm & Haas was added to the zeolites dispersion and blended mechanically. The paste was screen printed on a PET flexible substrate using 75 Shore A squeegee and 500 mesh stainless steel screen. The deposited layer was dried at 100°C for 10 minutes in a static oven. The quality of the dry layer, analyzed by optical microscopy, was rated "very good".

## Claims

1. Formulation of light-emitting material suitable for solution processing techniques comprising organic light emitting material housed in protective porous matrix material; a binder; and a solvent.

2. Formulation according to claim 1, wherein said protective matrix material is selected from microporous and mesoporous materials.

3. Formulation according to claim 2, wherein said protective matrix material is selected from the group comprising: zeolites, porous oxides, molecular sieves, silicoaluminophosphates and aluminosilicates.

4. Formulation according to claim 3, wherein said protective matrix material is a molecular sieve selected from among the molecular sieves MCM-41, MCM-48, HSM, SBA-15 and any of their combinations, preferably with Al/Si ratio between 5 and infinite.

5. Formulation according to claim 3, wherein said protective matrix material is a zeolite selected from among MCM-22, ZSM-5, Faujasite (NaY, NaX, or CsX type), and Linde Type L.

6. Formulation according to any one of the preceding claims, wherein said binder is selected from the group comprising: thermoplastic acrylic resins, including Paraloid®; styrene acrylic copolymers, polyacrylates, polyacrylic acid esters; cellulose esters and their derivatives and/or copolymers; polystyrene and its derivatives; polymethacrylates, including poly(methyl methacrylate), and their derivatives; methacrylic copolymers; poly(ethylene oxide); polyethylene glycol; colloidal silica, including Ludox®; poly(vinyl alcohol); poly(para-phenylene terephthalate); fluoropolymers, including poly(tetrafluoroethylene), poly(vinylidinefluoride); and their copolymers and/or derivatives.

7. Formulation according to any one of the preceding claims, wherein said solvent is a polar solvent.

8. Formulation according to any one of the preceding claims, wherein said solvent is selected from the group comprising:
esters, namely ethyl acetate, n-propyl acetate, isopropyl acetate, isobutyl acetate, n-butyl acetate and primary amyl acetate mixed isomers;
glycol ethers, including ethylene glycol monomethyl ether, ethylene glycol monoethyl ether, and diethylene glycol monomethyl ether;
glycol ether esters, including ethylene glycol monomethyl ether acetate, ethylene glycol monoethyl ether acetate and propylene glycol monomethyl ether acetate;
refined dimethyl esters of adipic, glutaric and succinic acids known as di-basic esters, and isobutyl isobutyrate; and
water, diethyl sulfate, dimethyl sulphoxide, 2-ethylhexanol, 2-ethylhexoic acid, 2-methyl butanol, diisobutyl carbinol, isobutanol, isophorone, isopropanol, methyl isobutyl carbinol, n-butanol, n-pentanol, n-propanol, primary amyl alcohol mixed isomers.

9. Formulation according to any one of the preceding claims, wherein said organic light emitting material is selected from the group comprising: light emitting polymers; light emitting oligomers, small molecules and combinations thereof.

10. Formulation according to claim 9, wherein said light emitting polymer is selected from the group comprising: polypyridine and its derivatives and/or copolymers; poly(p-phenylene vinylene) and its derivatives and/or copolymers; polyfluorenes and its derivatives and/or copolymers, including poly(9,9-dihexylfluorene) and its derivatives and/or co-polymers and poly(9,9-dioctylfluorene) and its derivatives and/or co-polymers; poly(3-alkylthiophenes), where alkyl can be from 6 to 16 C atoms.

11. Formulation according to claim 9, wherein said light emitting oligomer is selected form the group comprising: 4,4'-bis(9-ethyl-3-carbazovinylene)-1,1'-biphenyl; 9,10-bis[(9-ethyl-3-carbazoyl)-vinylenyl)]-anthracene; 4,4'-bis(diphenylvinylenyl)-biphenyl; 1,4-bis(9-ethyl-3-carbazovinylene)-2-methoxy-5-(2-ethylhexyloxy)benzene.

12. Formulation according to claim 9, wherein said small moleculesare selected from the group comprising: tris(2-phenylpyridine) iridium (III); tris(8-hydroxyquinolato) aluminum; tetra(2-methyl-8-hydroxyquinolato) boron; tris[1-phenyl-3-methyl-4-(2,2-dimethylpropan-1-oyl)-pyrazolin-5-one] terbium; lithium tetra(2-methyl-8-hydroxyquinolinato) boron; lithium tetra(8-hydroxyquinolinato) boron; bis(8-hydroxyquinolinato) zinc; bis(2-methyl-8-hydroxyquinolinato) zinc; tris(benzoylacetone)-mono-(phenanthroline) europium (III); tris(dibenzoylmethane)-mono-(phenanthroline) europium (III); tris(dibenzoylmethane)-mono-(5-aminophenanthroline) europium (III); tris(dinapthoylmethane)-mono-(phenanthroline) europium (III); tris(dibenzoylmethane)-mono-(4,7-diphenylphenanthroline) europium (III); tris(dibenzoylmethane)-mono-(4,7-dimethylphenanthroline) europium (III); tris(diphenoylmethane)-mono-(phenanthroline) europium (III); tris(dibenzoylmethane)-mono-(4,7-dihydroxy-phenanthroline) europium (III); tris(dibenzoylmethane)-mono-(4,7-dihydroxyloxy-phenanthroline) europium (III); tris(8-hydroxyquinoline) aluminium.

13. A method of manufacturing a light emitting device, wherein a layer of organic light emitting material is deposited by a solution processing technique using a formulation as claimed in any one of the preceding claims.

14. The method according to claim 13, wherein said layer of organic light emitting material is subjected to a drying step to remove the solvent.

15. The method according to claim 13 or 14, wherein said solution processing technique is one of screen, offset or inkjet printing.

16. A printable paste comprising a formulation as claimed in any one of claims 1 to 12.
